# EUROPEAN PATENT SPECIFICATION

(11) **EP 3 704 745 B1**
(45) Date of publication and mention of the grant of the patent: **24.02.2021**
(21) Application number: 18815877.8
(22) Date of filing: 15.11.2018
(51) Int. Cl.: H01L 31/0224, H01L 31/073, H01L 31/18

(54) **LAYER STRUCTURES FOR PHOTOVOLTAIC DEVICES AND PHOTOVOLTAIC DEVICES INCLUDING THE SAME**
SCHICHTSTRUKTUREN FÜR PHOTOVOLTAISCHE VORRICHTUNGEN UND PHOTOVOLTAISCHE VORRICHTUNGEN DAMIT
STRUCTURES DE COUCHE POUR DISPOSITIFS PHOTOVOLTAÏQUES ET DISPOSITIFS PHOTOVOLTAÏQUES LES COMPRENANT

(30) Priority: 16.11.2017 US 201762586955 P
(43) Date of publication of application: 09.09.2020
(73) Proprietor: First Solar, Inc, Tempe, AZ 85281 (US)
(72) Inventor: CHEN, Le, Perrysburg, OH 43551 (US); GUO, Jing, Perrysburg, OH 43551 (US); WEISS, Dirk, Perrysburg, OH 43551 (US)
(74) Representative: D Young & Co LLP
(86) International application number: PCT/US2018/061188
(87) International publication number: WO 2019/099607

(56) References cited:
- US-A1- 2012 067 421
- DAS S K ET AL: "PREPARATION AND PROPERTIES OF ELECTRODEPOSITED INDIUM TIN OXIDE/SNO2/CDTE AND INDIUM TIN OXIDE/SNO2/CDS/CDTE SOLAR CELLS", JOURNAL OF APPLIED PHYSICS, AMERICAN INSTITUTE OF PHYSICS, US, vol. 73, no. 2, 15 January 1993 (1993-01-15), pages 782-786, XP000334729, ISSN: 0021-8979, DOI: 10.1063/1.353338

## Description

### BACKGROUND

The present specification generally relates to layer structures for photovoltaic devices and, more specifically, to the use of particular combinations of materials and layer parameters to improve the efficiency of photovoltaic devices.

A photovoltaic device generates electrical power by converting light into electricity using semiconductor materials that exhibit the photovoltaic effect. Certain types of semiconductor material can be difficult to manufacture. For example, some material layers provided on the semiconductor material can have both desirable properties and undesirable properties. Unfortunately, the manufacturing process necessary to efficiently produce the semiconductor material can enhance the undesirable properties of the other material layers. Accordingly, material layers added to the photovoltaic device with the intent of improving efficiency, can ultimately decrease efficiency.

Accordingly, a need exists for alternative layer structures for use photovoltaic devices. Das S. K. et al. in "PREPARATION AND PROPERTIES OF ELECTRODEPOSITED INDIUM TIN OXIDE/SNO2/CDTE AND INDIUM TIN OXIDE/SNO2/ CDS/CDTE SOLAR CELLS", JOURNAL OF APPLIED PHYSICS, vol. 73, no. 2, pages 782 - 786 discloses a layer structure for a photovoltaic device comprising an ITO transparent conductive oxide layer and a layer of tin dioxide thereon.

### SUMMARY

Layer structures for use photovoltaic devices are provided herein. The features provided by the embodiments described herein will be more fully understood in view of the following detailed description, in conjunction with the drawings.

### BRIEF DESCRIPTION OF THE DRAWINGS

The embodiments set forth in the drawings are illustrative and exemplary in nature and not intended to limit the subject matter defined by the claims. The following detailed description of the illustrative embodiments can be understood when read in conjunction with the following drawings, where like structure is indicated with like reference numerals and in which:
FIG. 1 schematically depicts a layer structure according to one or more embodiments shown and described herein;
FIG. 2 schematically depicts a photovoltaic device incorporating the layer structure of FIG. 1 according to one or more embodiments shown and described herein;
FIG. 3 schematically depicts a substrate according to one or more embodiments shown and described herein;
FIG. 4 schematically depicts a photovoltaic device incorporating the layer structure of FIG. 1 according to one or more embodiments shown and described herein; and
FIG. 5 schematically depicts semiconductor layers for forming absorber layers of photovoltaic devices according to one or more embodiments shown and described herein; and
FIG. 6 graphically depicts indium diffusion into absorber layers of photovoltaic devices according to one or more embodiments shown and described herein.

### DETAILED DESCRIPTION

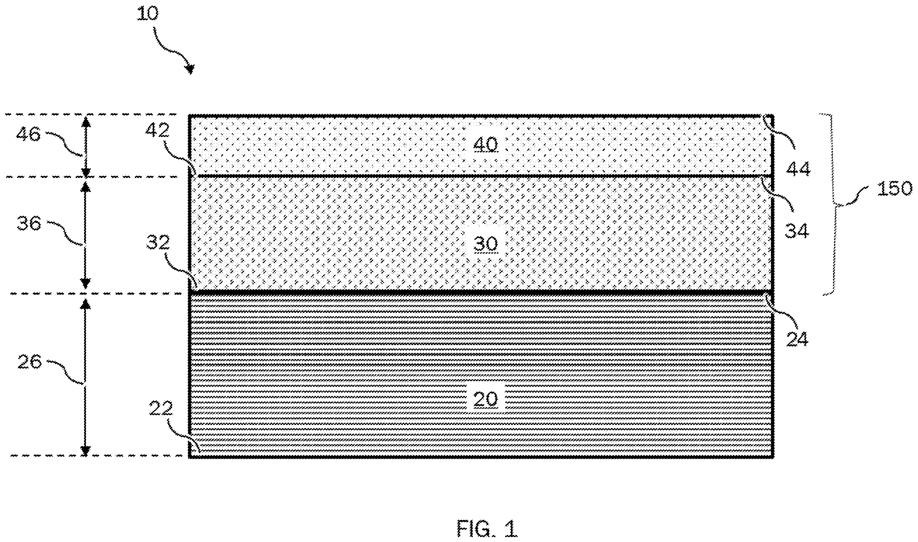

FIG.1 generally depicts an embodiment of a layer structure for photovoltaic devices. The layer structure can include a transparent conductive oxide (TCO) layer, a layer of tin dioxide disposed on the TCO layer, and a layer of zinc magnesium oxide disposed on the layer of tin dioxide, which cooperate to improve photovoltaic device performance. Various embodiments of the layer structure and photovoltaic devices incorporating the same will be described in more detail herein.

Referring now to FIG. 1, an embodiment of a layer structure 10 is schematically depicted. The layer structure 10 can be configured to mitigate the diffusion of deleterious chemicals through the layer structure 10. The layer structure 10 can include a TCO layer 20 configured to provide electrical contact to transport charge carriers generated by other layers disposed on the TCO layer 20. It is noted that, the term "disposed on" refers to layers disposed directly in contact with each other or indirectly by having intervening layers there between, unless otherwise specifically indicated. The phrase "adjacent to" as used herein means that two layers are disposed contiguously and without any intervening materials between at least a portion of the layers.

The TCO layer 20 can have a first surface 22 and a second surface 24 substantially facing an opposite direction of the first surface 22. The TCO layer 20 can have a thickness 26 defined between the first surface 22 and the second surface 24. The thickness 26 of the TCO layer 20 can be less than about 700 nm such as, for example, less than or equal to about 600 nm in one embodiment, between about 500 nm and about 30 nm in another embodiment, or between about 400 nm and about 50 nm in another embodiment.

Generally, the TCO layer 20 can be formed from one or more layers of n-type semiconductor material that is substantially transparent and has a wide band gap. Specifically, the wide band gap can have a larger energy value compared to the energy of the photons of the light, which can mitigate undesired absorption of light. In some embodiments, the TCO layer 20 can include indium tin oxide. The indium tin oxide can include more indium than tin. In some embodiments, the ratio of indium to tin, which is expressed as atomic ratio, can be greater than about 3:2 such as, for example, greater than about 65:35 in one embodiment, greater than about 7:3 in another embodiment, or between about 4:1 and about 99:1 in a further embodiment.

As is described in further detail below, some embodiments of the present disclosure have particular utility when the TCO layer 20 comprises indium tin oxide. However, the present disclosure is not limited to only indium tin oxide embodiments. For example, the TCO layer 20 can additionally include one or more layers of suitable material, including, but not limited to, tin dioxide, doped tin dioxide (e.g., F-SnO₂), or cadmium stannate. As used herein, the term "layer" can refer to a thickness of material provided upon a surface. Additionally, each layer can cover all or any portion of the surface.

The layer structure 10 can include a layer 30 and a layer 40 that cooperate to insulate the TCO layer 20 from layers disposed on the layer 40. The layer 30 can have a first surface 32 substantially facing the TCO layer 20 and a second surface 34 substantially facing an opposite direction of the first surface 32. The layer 30 can be adjacent to the TCO layer 20, i.e., the second surface 24 of the TCO layer 20 can contact the first surface 32 of the layer 30. According to the embodiments provided herein, the layer 30 can comprise tin dioxide (SnO₂) such as, for example, intrinsic tin dioxide. Indeed, in some embodiments, the layer 30 can consist of intrinsic tin dioxide. Accordingly, the layer 30 of tin dioxide can be adjacent to indium tin oxide of the TCO layer 20.

The layer 30 of tin dioxide can have a thickness 36 defined between the first surface 32 and the second surface 34. The thickness 36 of the layer 30 of tin dioxide can be less than about 150 nm such as, for example, less than about 100 nm in one embodiment, less than or equal to about 80 nm in another embodiment, between about 20 nm and about 60 nm in a further embodiment, or between about 30 nm and about 50 nm in yet another embodiment.

Referring still to FIG. 1, the layer 40 can have a first surface 42 substantially facing the layer 30 of tin dioxide and a second surface 44 substantially facing an opposite direction of the first surface 42. The layer 40 can be adjacent to the layer 30 of tin dioxide, i.e., the second surface 34 of the layer 30 can contact the first surface 42 of the layer 40. According to the embodiments provided herein, the layer 40 can comprise zinc magnesium oxide (e.g., Zn₁₋ₓMgₓO). In some embodiments, the layer 40 can consist of zinc magnesium oxide. The zinc magnesium oxide can be provided as an alloy of magnesium oxide and zinc oxide. The composition of the alloy can be varied such that the band gap of the layer 30 of zinc magnesium oxide is substantially equivalent to the band gap of the TCO layer 20. Generally, the layer 30 of zinc magnesium oxide includes more zinc oxide than magnesium oxide. In some embodiments, the ratio of zinc oxide to magnesium oxide, which is expressed as atomic ratio, can be greater than about 3:2 such as, for example, greater than about 2:1 in one embodiment, greater than about 7:3 in another embodiment, or between about 7:3 and about 1,000:1 in a further embodiment. The composition of zinc magnesium oxide can be expressed according to the formula Zn₁₋ₓMgₓO. In some embodiments, x can be less than or equal to about 0.4 such as, for example, greater than 0.0001 and less than about 0.35 in one embodiment, between about 0.005 and about 0.33 in another embodiment, or between about 0.005 and about 0.25 in a further embodiment.

The layer 40 of zinc magnesium oxide can have a thickness 46 defined between the first surface 42 and the second surface 44. The thickness 46 of the layer 40 of zinc magnesium oxide can be less than about 100 nm such as, for example, between about 5 nm and about 25 nm in one embodiment, or greater than or equal to about 15 nm and less than or equal to about 20 nm in another embodiment.

In some embodiments, the thickness 36 of the layer 30 of tin dioxide can be greater than or equal to the thickness 46 of the layer 40 of zinc magnesium oxide. For example, a ratio of the thickness 36 of the layer 30 of tin dioxide to the thickness 46 of the layer 40 of zinc magnesium oxide can be greater than or equal to about 1 such as, for example, between about 1 and about 15 in one embodiment, or between about 1.5 and about 12 in another embodiment. Alternatively or additionally, a sum of the thickness 36 of the layer 30 of tin dioxide and the thickness 46 of the layer 40 of zinc magnesium oxide can be less than or equal to about 200 nm such as, for example, less than or equal to about 100 nm in one embodiment, or between about 45 nm and about 85 nm in another embodiment.

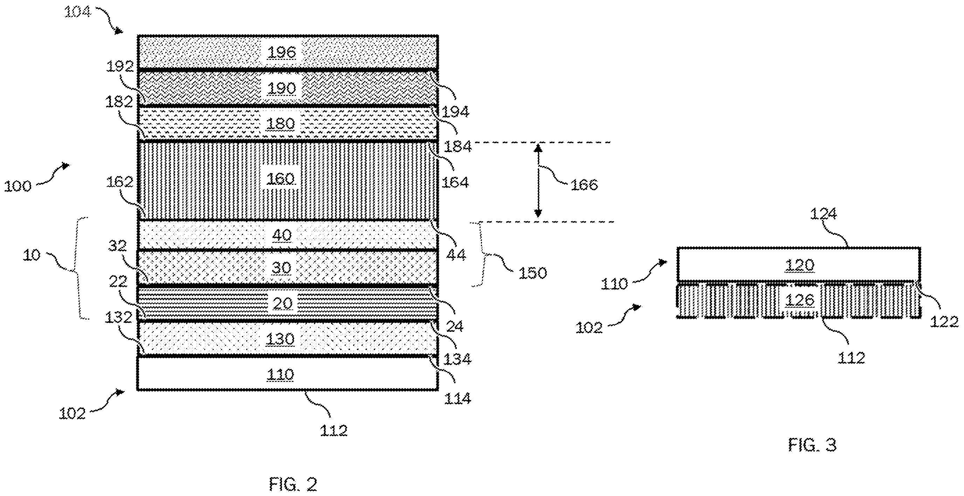

Referring now to FIG. 2, an embodiment of a photovoltaic device 100 is schematically depicted. The photovoltaic device 100 can be configured to receive light and transform light into electrical signals, e.g., photons can be absorbed from the light and transformed into electrical signals via the photovoltaic effect. Accordingly, the photovoltaic device 100 can define an energy side 102 configured to be exposed to a light source such as, for example, the sun. The photovoltaic device 102 can also define an opposing side 104 offset from the energy side 102. It is noted that the term "light" can refer to various wavelengths of the electromagnetic spectrum such as, but not limited to, wavelengths in the ultraviolet (UV), infrared (IR), and visible portions of the electromagnetic spectrum. The photovoltaic device 100 can include a plurality of layers disposed between the energy side 102 and the opposing side 104.

The photovoltaic device 100 can include a substrate 110 configured to facilitate the transmission of light into the photovoltaic device 100. The substrate 110 can be disposed at the energy side 102 of the photovoltaic device 100. Referring collectively to FIGS. 2 and 3, the substrate 110 can have a first surface 112 substantially facing the energy side 102 of the photovoltaic device 100 and a second surface 114 substantially facing the opposing side 104 of the photovoltaic device 100. One or more layers of material can be disposed between the first surface 112 and the second surface 114 of the substrate 110.

The substrate 110 can include a transparent layer 120 having a first surface 122 substantially facing the energy side 102 of the photovoltaic device 100 and a second surface 124 substantially facing the opposing side 104 of the photovoltaic device 100. The transparent layer 120 can be formed from a substantially transparent material such as, for example, glass. Suitable glass can include soda-lime glass, or any glass with reduced iron content. The transparent layer 120 can have any suitable transmittance, including about 450 nm to about 800 nm in some embodiments. The transparent layer 120 may also have any suitable transmission percentage, including, for example, more than about 50% in one embodiment, more than about 60% in another embodiment, more than about 70% in yet another embodiment, more than about 80% in a further embodiment, or more than about 85% in still a further embodiment. In one embodiment, transparent layer 120 can be formed from a glass with about 90% transmittance. Optionally, the substrate 110 can include a coating 126 applied to the first surface 122 of the transparent layer 120. The coating 126 can be configured to interact with light or to improve durability of the substrate 110 such as, but not limited to, an antireflective coating, an antisoiling coating, or a combination thereof.

Referring again to FIG. 2, the photovoltaic device 100 can include a barrier layer 130 configured to mitigate diffusion of contaminants (e.g. sodium) from the substrate 110, which could result in degradation or delamination. The barrier layer 130 can have a first surface 132 substantially facing the energy side 102 of the photovoltaic device 100 and a second surface 134 substantially facing the opposing side 104 of the photovoltaic device 100. In some embodiments, the barrier layer 130 can be provided adjacent to the substrate 110. For example, the first surface 132 of the barrier layer 130 can be provided upon the second surface 114 of the substrate 100.

Generally, the barrier layer 130 can be substantially transparent, thermally stable, with a reduced number of pin holes and having high sodium-blocking capability, and good adhesive properties. Alternatively or additionally, the barrier layer 130 can be configured to apply color suppression to the light. The barrier layer 130 can include one or more layers of suitable material, including, but not limited to, tin oxide, silicon dioxide, aluminum-doped silicon oxide, silicon oxide, silicon nitride, or aluminum oxide. The barrier layer 130 can have any suitable thickness bounded by the first surface 132 and the second surface 134, including, for example, more than about 500 Å in one embodiment, more than about 750 Å in another embodiment, or less than about 1200 Å in a further embodiment.

Referring collectively to FIGS. 1 and 2, the photovoltaic device 100 can include the TCO layer 20, which can be configured to provide electrical contact to transport charge carriers generated by the photovoltaic device 100. The first surface 22 of the TCO layer 20 can substantially face the energy side 102 of the photovoltaic device 100 and the second surface 24 can substantially face the opposing side 104 of the photovoltaic device 100. In some embodiments, the TCO layer 20 can be provided adjacent to the barrier layer 130. For example, the first surface 22 of the TCO 20 can be provided upon the second surface 134 of the barrier layer 130.

The photovoltaic device 100 can include a buffer layer 150 configured to provide an insulating layer between the TCO layer 20 and any semiconductor layers disposed on the buffer layer 150. In some embodiments, the buffer layer 150 can consist of the layer 30 of tin dioxide and the layer 40 of zinc magnesium oxide. The buffer layer 150 can be provided adjacent to the TCO layer 20 such that the first surface 22 substantially faces the energy side 102 of the photovoltaic device 100 and the second surface 44 substantially faces the opposing side 104 of the photovoltaic device 100. Accordingly, the photovoltaic device 100 can include the layer structure 10.

Referring again to FIG. 1, the photovoltaic device 100 can include an absorber layer 160 configured to form a p-n junction within the photovoltaic device 100. Accordingly, absorbed photons of the light can free electron-hole pairs and generate carrier flow, which can yield electrical power. The absorber layer 160 can have a first surface 162 substantially facing the energy side 102 of the photovoltaic device 100 and a second surface 164 substantially facing the opposing side 104 of the photovoltaic device 100. A thickness of the absorber layer 160 can be defined between the first surface 162 and the second surface 164. The thickness of the absorber layer 160 can be between about 0.5 µm to about 10 µm such as, for example, between about 1 µm to about 7 µm in one embodiment, or between about 2 µm to about 5 µm in another embodiment.

According to the embodiments described herein, the absorber layer 160 can be formed from a p-type semiconductor material having an excess of positive charge carriers, i.e., holes. The absorber layer 160 can include any suitable p-type semiconductor material such as group II-VI semiconductors. Specific examples include, but are not limited to, semiconductor materials formed from cadmium, tellurium, selenium, or any combination thereof. Suitable examples include, but are not limited to, cadmium telluride, ternaries of cadmium, selenium and tellurium (e.g., CdSeₓTe₁₋ₓ,), ternaries of cadmium, sulfur, and tellurium (e.g., CdSₓTe₁₋ₓ,), and quaternaries comprising cadmium, selenium and tellurium. In embodiments where the absorber layer 160 comprises selenium and cadmium, the atomic percent of the selenium can be greater than about 0 atomic percent and less than about 20 atomic compared to cadmium. It is noted that the atomic percent described herein is representative of the entirety of the absorber layer 160, the atomic percentage of material at a particular location within the absorber layer 160 can vary with thickness compared to the overall composition of the absorber layer 160. In embodiments where the absorber layer 160 comprises sulfur and cadmium, the atomic percent of the sulfur can be greater than about 0 atomic percent and less than about 20 atomic compared to cadmium. It is noted that the concentration of tellurium can vary through the thickness of the absorber layer 160. For example, when the absorber layer 160 comprises a ternary of cadmium, selenium, and tellurium (CdSeₓTe₁₋ₓ), x can vary in the absorber layer 160 with distance from the first surface 162 of the absorber layer 160. Similarly, when the absorber layer 160 comprises a ternary of cadmium, sulfur, and tellurium (CdSₓTe₁₋ₓ), x can vary in the absorber layer 160 with distance from the first surface 162 of the absorber layer 160.

According to the embodiments provided herein, the absorber layer 160 can be doped with a dopant configured to manipulate the charge carrier concentration. In some embodiments, the absorber layer can be doped with a group I or V dopant such as, for example, copper, arsenic, phosphorous, antimony, or a combination thereof. The total dosage of the dopant within the absorber layer 160 can be controlled. Alternatively or additionally, the amount of the dopant can vary with distance from the first surface 162 of the absorber layer 160.

Referring still to FIG. 2, the p-n junction can be formed by providing the absorber layer 160 sufficiently close to a portion of the photovoltaic device 100 having an excess of negative charge carriers, i.e., electrons. In some embodiments, the absorber layer 160 can be provided adjacent to n-type semiconductor material. Alternatively, one or more intervening layers can be provided between the absorber layer 160 and n-type semiconductor material. In some embodiments, the absorber layer 160 can be provided adjacent to the buffer layer 150. For example, the first surface 162 of the absorber layer 160 can be provided upon the second surface 44 of the layer 40 of zinc magnesium oxide of the buffer layer 150.

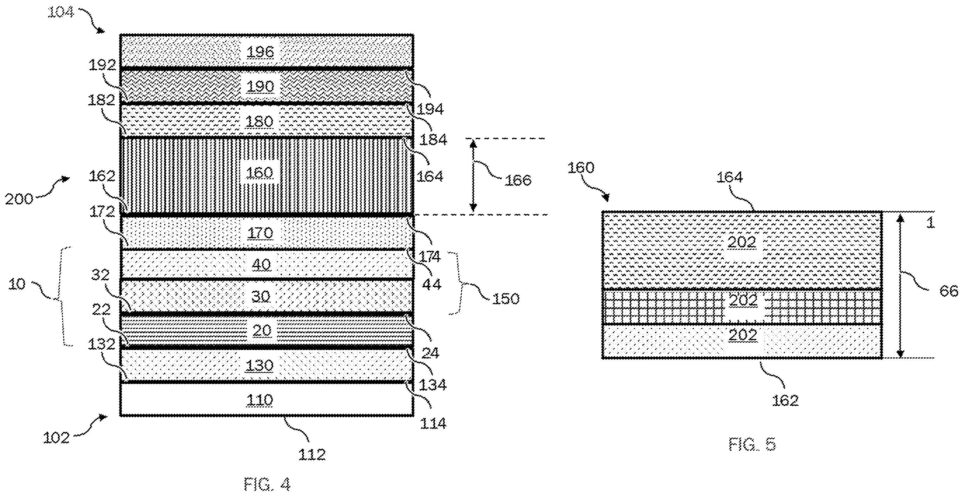

Referring now to FIG. 4, in some embodiments, a photovoltaic device 200 can include a window layer 170 comprising n-type semiconductor material. The absorber layer 160 can be formed adjacent to the window layer 170. The window layer 170 can have a first surface 172 substantially facing the energy side 102 of the photovoltaic device 100 and a second surface 174 substantially facing the opposing side 104 of the photovoltaic device 100. In some embodiments, the window layer 170 can be positioned between the absorber layer 160 and the TCO layer 20. In one embodiment, the window layer 170 can be positioned between the absorber layer 160 and the buffer layer 150. The window layer 170 can include any suitable material, including, for example, cadmium sulfide, zinc sulfide, cadmium zinc sulfide, zinc magnesium oxide, or any combination thereof.

Referring collectively to FIGS. 2 and 4, the photovoltaic device 100 can include a back contact layer 180 configured to mitigate undesired alteration of the dopant and to provide electrical contact to the absorber layer 160. The back contact layer 180 can have a first surface 182 substantially facing the energy side 102 of the photovoltaic device 100 and a second surface 184 substantially facing the opposing side 104 of the photovoltaic device 100. A thickness of the back contact layer 180 can be defined between the first surface 182 and the second surface 184. The thickness of the back contact layer 180 can be between about 5 nm to about 200 nm such as, for example, between about 10 nm to about 50 nm in one embodiment.

In some embodiments, the back contact layer 180 can be provided adjacent to the absorber layer 160. For example, the first surface 182 of the back contact layer 180 can be provided upon the second surface 164 of the absorber layer 160. In some embodiments, the back contact layer 180 can include binary or ternary combinations of materials from groups I, II, VI, such as for example, one or more layers containing zinc, copper, cadmium and tellurium in various compositions. Further exemplary materials include, but are not limited to, zinc telluride doped with copper telluride, or zinc telluride alloyed with copper telluride.

The photovoltaic device 100 can include a conducting layer 190 configured to provide electrical contact with the absorber layer 160. The conducting layer 190 can have a first surface 192 substantially facing the energy side 102 of the photovoltaic device 100 and a second surface 194 substantially facing the opposing side 104 of the photovoltaic device 100. In some embodiments, the conducting layer 190 can be provided adjacent to the back contact layer 180. For example, the first surface 192 of the conducting layer 190 can be provided upon the second surface 184 of the back contact layer 180. The conducting layer 190 can include any suitable conducting material such as, for example, one or more layers of nitrogen-containing metal, silver, nickel, copper, aluminum, titanium, palladium, chrome, molybdenum, gold, or the like. Suitable examples of a nitrogen-containing metal layer can include aluminum nitride, nickel nitride, titanium nitride, tungsten nitride, selenium nitride, tantalum nitride, or vanadium nitride.

The photovoltaic device 100 can include a back support 196 configured to cooperate with the substrate 110 to form a housing for the photovoltaic device 100. The back support 196 can be disposed at the opposing side 102 of the photovoltaic device 100. For example, the back support 196 can be formed adjacent to conducting layer 190. The back support 196 can include any suitable material, including, for example, glass (e.g., soda-lime glass).

Referring collectively to FIGS. 3, 4, and 5, the absorber layer 160 can be formed from a plurality of semiconductor layers 202. For example, the semiconductor layers 202 can be provided as a stack of thin films deposited upon one another using any known deposition technique, including vapor transport deposition. Each of the semiconductor layers 202 can include any suitable p-type semiconductor material, including, for example, semiconductor materials formed from II-VI materials. In some embodiments, the material composition of the semiconductor layers 202 can vary. After deposition, the semiconductor layers 202 can be annealed, e.g., subjected to a temperature between about 400° C and about 500° C for about 10 to about 20 minutes. The annealing can cause the semiconductor layers 202 to diffuse into one another to form a blended material composition having the characteristics described above with respect to the absorber layer 160. In some embodiments, the semiconductor layers 202 can be annealed in a chlorine and oxygen containing atmosphere, i.e., a chloride heat treatment (CHT).

During the annealing process, the composition of the TCO layer 20 can have a deleterious effect upon the absorber layer 160. For example, when the TCO layer 20 comprises indium tin oxide, indium can diffuse through one or more layers into the absorber layer 160. The diffusion of indium can anti-dope the absorber layer 160, which can reduce the efficiency of the photovoltaic device 100, 200. Applicant has discovered that the use of zinc magnesium oxide in the buffer layer 150 can block indium diffusion into the absorber layer 160.

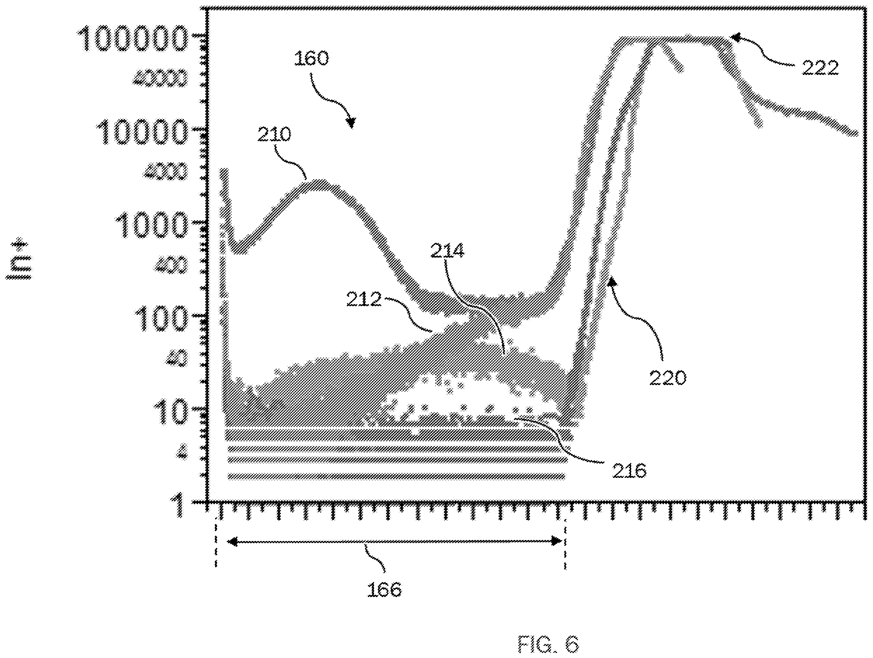

Referring now to FIG. 6, a bivariate fit of indium diffusion through the thickness 166 of the absorber layer 160 is graphically depicted. Specifically, the graph includes a plot 210 corresponding to a first comparative example, a plot 212 corresponding to a second comparative example, a plot 214 corresponding to a first example, and a plot 216 corresponding to a second example. Each of the plots 210, 212, 214, 216 includes: an absorber layer 160, which comprises CdTe; a buffer region 220 generally corresponding to the buffer layer 150, which includes the linearly sloped region; and an indium region 222 generally corresponding to the TCO layer 20 comprising indium tin oxide.

The first comparative example, plot 210, was formed without any zinc magnesium oxide in the buffer region 220 and subjected to a CHT. The second comparative example, plot 212, was formed without any zinc magnesium oxide in the buffer region 220 and subjected to an elevated temperature of about 200° C. The plot 210 of the first comparative example shows more aggressive indium penetration through the thickness 166 of the absorber layer 160. The plot 212 of the second comparative example generally tracks with the plot 210 in the buffer region 220 and in the initial portion of the absorber layer 160. Plot 212 gradually decreases to a suitable level of indium, i.e., at the intersection with plot 214. The first example, plot 214, was formed with a 20 nm thick layer of zinc magnesium oxide in the buffer region 220 and subjected to a CHT. The second example, plot 216, was formed with an 80 nm thick layer of zinc magnesium oxide in the buffer region 220 and subjected to a CHT. The plot 212 demonstrated a reduction in indium diffusion compared to both plot 210 of the first comparative example and plot 212 of the second comparative example. Plot 216 of the second example demonstrated further reduction in indium diffusion compared to plot 214 of the first example. Generally, the absorber layer 160 can include a diffused amount of indium with an average atomic concentration of less than about 6 x 10⁻¹⁷ atom/cm³ such as, for example, the average atomic concentration of diffused indium can be less than about 4 x 10⁻¹⁷ atom/cm³ in one embodiment, or the average atomic concentration of diffused indium can be between about 1 x 10⁻¹⁴ atom/cm³ and about 5 x 10⁻¹⁷ atom/cm³ in another embodiment.

Referring again to FIGS. 1, 2, and 4, the inclusion of the layer 30 of tin dioxide can further improve the operation of the photovoltaic device 100, 200. Applicant has discovered that the layer 40 of zinc magnesium oxide may not be sufficient to protect the TCO layer 20 during CHT. Without being bound to theory, it is believed that Cl- can diffuse into the TCO layer 20 during CHT. Such diffusion can cause an undesirable increase in sheet resistance of the TCO layer 20.

Comparative Examples 3-6 and Examples 3 and 4 were prepared by forming devices forming a barrier of 50 nm SiAlON, and depositing a TCO of 100 nm of indium tin oxide adjacent to the barrier. Various buffers were deposited adjacent to the TCO to form the examples. Each example was subjected to CHT. After the CHT, the sheet resistance of each TCO was measured using a Delcom device. The results of the testing are tabulated below in Table 1, which summarizes the percent improvement of the devices compared to Comparative Example 3. As provided in Table 1, Examples 3 and 4 which include a buffer formed of both tin dioxide and zinc magnesium oxide demonstrated improvement compared to any of the Comparative Examples having buffers of zinc magnesium oxide alone. Indeed, improvement was achieved even with buffers having less total thickness.

**Table 1**

| | Buffer | Improvement Sheet Resistance (%) |
|---|---|---|
| Comparative Example 3 | 40 nm (zinc magnesium oxide) | 0 |
| Comparative Example 4 | 40 nm (zinc magnesium oxide) | 4 |
| Comparative Example 5 | 60 nm (zinc magnesium oxide) | 8 |
| Comparative Example 6 | 60 nm (zinc magnesium oxide) | 0 |
| Example 3 | 20 nm (tin dioxide) / 20 nm (zinc magnesium oxide) | 27 |
| Example 4 | 20 nm (tin dioxide) / 20 nm (zinc magnesium oxide) | 26 |

Further testing was conducted to compare photovoltaic devices with a buffer of tin dioxide and no zinc magnesium oxide to photovoltaic devices with a buffer of both tin dioxide and zinc magnesium oxide. The photovoltaic devices with a buffer of both tin dioxide and zinc magnesium oxide demonstrated about 10% to about 25% improvement in device efficiency compared to photovoltaic devices with a buffer of tin dioxide and no zinc magnesium oxide. Without being bound to theory, it is believed that zinc magnesium oxide, when used in conjunction to tin dioxide, can improve band alignment, reduce junction defects, and improve adhesion.

According to the embodiments described herein, a layer structure for a photovoltaic device can include a transparent conductive oxide layer, a layer of tin dioxide, and a layer of zinc magnesium oxide. The transparent conductive oxide layer can include indium tin oxide. The layer of tin dioxide can be disposed on the indium tin oxide of the transparent conductive oxide layer. The layer of zinc magnesium oxide can be adjacent to the layer of tin dioxide. The layer of zinc magnesium oxide can be an alloy of zinc oxide and magnesium oxide.

According to the embodiments provided herein, a photovoltaic device can include a transparent conductive oxide layer, a layer of tin dioxide, a layer of zinc magnesium oxide, and an absorber layer. The transparent conductive oxide layer can include indium tin oxide. The layer of tin dioxide can be disposed on the indium tin oxide of the transparent conductive oxide layer. The layer of zinc magnesium oxide can be adjacent to the layer of tin dioxide. The layer of zinc magnesium oxide can be an alloy of zinc oxide and magnesium oxide. The absorber layer can be disposed on the layer of zinc magnesium oxide. The absorber layer can include cadmium, tellurium, selenium, or any combination thereof.

It is noted that the terms "substantially" and "about" may be utilized herein to represent the inherent degree of uncertainty that may be attributed to any quantitative comparison, value, measurement, or other representation. These terms are also utilized herein to represent the degree by which a quantitative representation may vary from a stated reference without resulting in a change in the basic function of the subject matter at issue.

## Claims

1. A layer structure for a photovoltaic device comprising:
a transparent conductive oxide layer comprising indium tin oxide (20); and
a layer of tin dioxide (30) adjacent to the indium tin oxide of the transparent conductive oxide layer, **characterised by**
a layer of zinc magnesium oxide (40) adjacent to the layer of tin dioxide, wherein the layer of zinc magnesium oxide is an alloy of zinc oxide and magnesium oxide.

2. A photovoltaic device (100) comprising:
a transparent conductive oxide layer comprising indium tin oxide (20);
a layer of tin dioxide (30) disposed on the indium tin oxide of the transparent conductive oxide layer;
a layer of zinc magnesium oxide (40) adjacent to the layer of tin dioxide, wherein the layer of zinc magnesium oxide is an alloy of zinc oxide and magnesium oxide; and
an absorber layer (160) disposed on the layer of zinc magnesium oxide, wherein the absorber layer comprises cadmium, tellurium, selenium, or any combination thereof.

3. The photovoltaic device of claim 2, wherein the absorber layer comprises a ternary of cadmium, selenium, and tellurium.

4. The photovoltaic device of claim 2, wherein the absorber layer comprises a diffused amount of indium with an average atomic concentration in the absorber layer of less than about 6 x 10⁻¹⁷ atom/cm³.

5. The layer structure or photovoltaic device of any of claims 1, and 2-4, wherein the alloy comprises more zinc oxide than magnesium oxide.

6. The layer structure or photovoltaic device of any of claims 1, and 2-5, wherein a ratio of zinc oxide to magnesium oxide in the alloy is greater than 2:1.

7. The layer structure or photovoltaic device of any of claims 1, and 2-6, wherein the tin dioxide is intrinsic tin dioxide.

8. The layer structure or photovoltaic device of any of claims 1, and 2-7, wherein a thickness of the layer of tin dioxide is less than about 150 nm.

9. The layer structure or photovoltaic device of any of claims 1, and 2-8, wherein a thickness of the layer of zinc magnesium oxide is less than about 100 nm.

10. The layer structure or photovoltaic device of any of claims 1, and 2-9, wherein a thickness of the layer of tin dioxide is greater than or equal to the thickness of the layer of zinc magnesium oxide.

11. The layer structure or photovoltaic device of any of claims 1, and 2-10, wherein a ratio of the thickness of the layer of tin dioxide to the thickness of the layer of zinc magnesium oxide is between about 1 and about 15.

12. The layer structure or photovoltaic device of any of claims 1, and 2-11, wherein a sum of the thickness of the layer of tin dioxide and the thickness of the layer of zinc magnesium oxide is less than or equal to about 200 nm.

13. The photovoltaic device of any of claims 2-12, wherein the layer of tin dioxide is adjacent to the indium tin oxide of the transparent conductive oxide layer.

14. The layer structure or photovoltaic device of any of claims 1, and 2-13, wherein a ratio of indium to tin in the transparent conductive oxide layer is greater than about 3:2.

## Patentansprüche

1. Schichtstruktur für eine photovoltaische Vorrichtung, umfassend:
eine transparente leitfähige Oxidschicht, die Indiumzinnoxid (20) umfasst; und
eine Schicht aus Zinndioxid (30) angrenzend an das Indiumzinnoxid der transparenten leitfähigen Oxidschicht, **gekennzeichnet durch**
eine Schicht aus Zinkmagnesiumoxid (40) angrenzend an die Schicht aus Zinndioxid, wobei die Schicht aus Zinkmagnesiumoxid eine Legierung aus Zinkoxid und Magnesiumoxid ist.

2. Photovoltaische Vorrichtung (100), umfassend:
eine transparente leitfähige Oxidschicht, die Indiumzinnoxid (20) umfasst;
eine Schicht aus Zinndioxid (30), die auf dem Indiumzinnoxid der transparenten leitfähigen Oxidschicht angeordnet ist;
eine Schicht aus Zinkmagnesiumoxid (40) angrenzend an die Schicht aus Zinndioxid, wobei die Schicht aus Zinkmagnesiumoxid eine Legierung aus Zinkoxid und Magnesiumoxid ist; und
eine Absorptionsschicht (160), die auf der Schicht aus Zinkmagnesiumoxid angeordnet ist, wobei die Absorptionsschicht Cadmium, Tellur, Selen oder jede beliebige Kombination daraus umfasst.

3. Photovoltaische Vorrichtung nach Anspruch 2, wobei die Absorptionsschicht eine ternäre Verbindung aus Cadmium, Selen und Tellur umfasst.

4. Photovoltaische Vorrichtung nach Anspruch 2, wobei die Absorptionsschicht eine diffundierte Menge Indium mit einer durchschnittlichen Atomkonzentration in der Absorptionsschicht von unter ungefähr 6 x 10⁻¹⁷ Atomen/cm² umfasst.

5. Schichtstruktur oder photovoltaische Vorrichtung nach einem der Ansprüche 1 und 2 bis 4, wobei die Legierung mehr Zinkoxid als Magnesiumoxid umfasst.

6. Schichtstruktur oder photovoltaische Vorrichtung nach einem der Ansprüche 1 und 2 bis 5, wobei ein Verhältnis von Zinkoxid zu Magnesiumoxid in der Legierung über 2:1 beträgt.

7. Schichtstruktur oder photovoltaische Vorrichtung nach einem der Ansprüche 1 und 2 bis 6, wobei das Zinndioxid intrinsisches Zinndioxid ist.

8. Schichtstruktur oder photovoltaische Vorrichtung nach einem der Ansprüche 1 und 2 bis 7, wobei eine Dicke der Schicht aus Zinndioxid unter ungefähr 150 nm beträgt.

9. Schichtstruktur oder photovoltaische Vorrichtung nach einem der Ansprüche 1 und 2 bis 8, wobei eine Dicke der Schicht aus Zinkmagnesiumoxid unter ungefähr 100 nm beträgt.

10. Schichtstruktur oder photovoltaische Vorrichtung nach einem der Ansprüche 1 und 2 bis 9, wobei eine Dicke der Schicht aus Zinndioxid größer gleich der Dicke der Schicht aus Zinkmagnesiumoxid ist.

11. Schichtstruktur oder photovoltaische Vorrichtung nach einem der Ansprüche 1 und 2 bis 10, wobei ein Verhältnis der Dicke der Schicht aus Zinndioxid zur Dicke der Schicht aus Zinkmagnesiumoxid zwischen ungefähr 1 und ungefähr 15 beträgt.

12. Schichtstruktur oder photovoltaische Vorrichtung nach einem der Ansprüche 1 und 2 bis 11, wobei eine Summe aus der Dicke der Schicht aus Zinndioxid und der Dicke der Schicht aus Zinkmagnesiumoxid kleiner gleich ungefähr 200 nm beträgt.

13. Photovoltaische Vorrichtung nach einem der Ansprüche 2 bis 12, wobei die Schicht aus Zinndioxid an das Indiumzinnoxid der transparenten leitfähigen Oxidschicht angrenzt.

14. Schichtstruktur oder photovoltaische Vorrichtung nach einem der Ansprüche 1 und 2 bis 13, wobei ein Verhältnis aus Indium zu Zinn in der transparenten leitfähigen Oxidschicht über ungefähr 3:2 beträgt.

## Revendications

1. Structure de couches pour un dispositif photovoltaïque comprenant :
une couche d'oxyde conductrice transparente comprenant de l'oxyde d'indium-étain (20) ; et
une couche de dioxyde d'étain (30) adjacente à l'oxyde d'indium-étain de la couche d'oxyde conductrice transparente, **caractérisée par**
une couche d'oxyde de zinc-magnésium (40) adjacente à la couche de dioxyde d'étain, la couche d'oxyde de zinc-magnésium étant un alliage d'oxyde de zinc et d'oxyde de magnésium.

2. Dispositif photovoltaïque (100) comprenant :
une couche d'oxyde conductrice transparente comprenant de l'oxyde d'indium-étain (20) ;
une couche de dioxyde d'étain (30) disposée sur l'oxyde d'indium-étain de la couche d'oxyde conductrice transparente ;
une couche d'oxyde de zinc-magnésium (40) adjacente à la couche de dioxyde d'étain, la couche d'oxyde de zinc-magnésium étant un alliage d'oxyde de zinc et d'oxyde de magnésium ; et
une couche d'absorbeur (160) disposée sur la couche d'oxyde de zinc-magnésium, la couche d'absorbeur comprenant du cadmium, du tellure, du sélénium, ou une quelconque combinaison correspondante.

3. Dispositif photovoltaïque selon la revendication 2, la couche d'absorbeur comprenant un ternaire de cadmium, de sélénium, et de tellure.

4. Dispositif photovoltaïque selon la revendication 2, la couche d'absorbeur comprenant une quantité diffuse d'indium avec une concentration atomique moyenne dans la couche d'absorbeur inférieure à environ 6 x 10⁻¹⁷ atome/cm³.

5. Structure de couches ou dispositif photovoltaïque selon l'une quelconque des revendications 1, et 2 à 4, l'alliage comprenant plus d'oxyde de zinc que d'oxyde de magnésium.

6. Structure de couches ou dispositif photovoltaïque selon l'une quelconque des revendications 1, et 2 à 5, un rapport d'oxyde de zinc sur oxyde de magnésium dans l'alliage étant supérieur à 2 : 1.

7. Structure de couches ou dispositif photovoltaïque selon l'une quelconque des revendications 1, et 2 à 6, le dioxyde d'étain étant du dioxyde d'étain intrinsèque.

8. Structure de couches ou dispositif photovoltaïque selon l'une quelconque des revendications 1, et 2 à 7, une épaisseur de la couche de dioxyde d'étain étant inférieure à environ 150 nm.

9. Structure de couches ou dispositif photovoltaïque selon l'une quelconque des revendications 1, et 2 à 8, une épaisseur de la couche d'oxyde de zinc-magnésium étant inférieure à environ 100 nm.

10. Structure de couches ou dispositif photovoltaïque selon l'une quelconque des revendications 1, et 2 à 9, une épaisseur de la couche de dioxyde d'étain étant supérieure ou égale à l'épaisseur de la couche d'oxyde de zinc-magnésium.

11. Structure de couches ou dispositif photovoltaïque selon l'une quelconque des revendications 1, et 2 à 10, un rapport de l'épaisseur de la couche de dioxyde d'étain sur l'épaisseur de la couche d'oxyde de zinc-magnésium étant compris entre environ 1 et environ 15.

12. Structure de couches ou dispositif photovoltaïque selon l'une quelconque des revendications 1, et 2 à 11, une somme de l'épaisseur de la couche de dioxyde d'étain et de l'épaisseur de la couche d'oxyde de zinc-magnésium étant inférieure ou égale à environ 200 nm.

13. Dispositif photovoltaïque selon l'une quelconque des revendications 2 à 12, la couche de dioxyde d'étain étant adjacente à l'oxyde d'indium-étain de la couche d'oxyde conductrice transparente.

14. Structure de couches ou dispositif photovoltaïque selon l'une quelconque des revendications 1, et 2 à 13, un rapport d'indium sur étain dans la couche d'oxyde conductrice transparente étant supérieur à environ 3 : 2.
